# EUROPÄISCHE PATENTSCHRIFT

(11) **EP 2 523 208 B1**
(45) Veröffentlichungstag und Bekanntmachung des Hinweises auf die Patenterteilung: **12.06.2013**
(21) Anmeldenummer: 12179537.1
(22) Anmeldetag: 23.04.2010
(51) Int. Cl.: H01L 21/00, H01L 21/67

(54) **Lösungsmittelbehälter und Verfahren zum Lösen einer Verbindungsschicht**
Device and method for releasing a product substrate from a holder substrate
Dispositif et procédé de séparation d'un substrat de produit et d'un substrat de support

(43) Veröffentlichungstag der Anmeldung: 14.11.2012
(62) Teilanmeldung aus: 10004313.2
(73) Patentinhaber: EV Group GmbH, 4782 St. Florian am Inn (AT)
(72) Erfinder: Lindner, Friedrich Paul, 4780 Schärding/Inn (AT); Burggraf, Jürgen, 4780 Schärding/Inn (AT)
(74) Vertreter: Schweiger, Johannes

(56) Entgegenhaltungen:
- US-A1- 2009 305 617

## Beschreibung

Die Erfindung betrifft einen Lösungsmittelbehälter zum Lösen einer Verbindungsschicht gemäß Anspruch 1, ein korrespondierendes Verfahren gemäß Anspruch 6.

Das Rückdünnen von Produktsubstraten ist in der Halbleiterindustrie häufig erforderlich und kann mechanisch und/oder chemisch erfolgen. Zum Rückdünnen werden die Produktsubstrat in der Regel auf einen Träger vorübergehend fixiert, wobei es für die Fixierung verschiedene Methoden gibt. Als Trägermaterial werden beispielsweise Folien, Glassubstrate oder Siliziumwafer verwendet.

Die Druckschrift US 2009/305617 A1 zeigt eine Trägervorrichtung zur Aufnahme von Wafern mit einer Zuführkammer für Lösungsmittel zur Reduzierung der Bondstärke. Weitere Vorrichtungen sind in der US 2007/295458 A1 und der DE 197 34 635 A1 gezeigt.

In Abhängigkeit von den verwendeten Trägermaterialien und der verwendeten Verbindungsschicht zwischen Träger und Produktsubstrat sind verschiedene Verfahren zur Auflösung oder Zerstörung der Verbindungsschicht bekannt, wie beispielsweise die Verwendung von UV-Licht, Laserstrahlen, Temperatureinwirkung oder Lösungsmittel.

Das Ablösen stellt sich zunehmend als einer der kritischsten Prozessschritte dar, da die dünnen Substrate mit Substratdicken von wenigen µm beim Ablösen/Abziehen leicht brechen oder durch die für den Vorgang des Ablösens notwendigen Kräfte Schaden erleiden.

Darüber hinaus haben die dünnen Substrate kaum bis keine Formstabilität und rollen sich typischerweise ohne Stützmaterial ein. Während der Handhabung der rückgedünnten Wafer ist mithin eine Fixierung und Unterstützung der Wafer praktisch unumgänglich.

Es ist daher die Aufgabe der vorliegenden Erfindung, einen Lösungsmittelbehälter und ein Verfahren anzugeben, um eine Verbindungsschicht zwischen einem Produktsubstrat möglichst schonend zu lösen.

Diese Aufgabe wird mit den Merkmalen der Ansprüche 1 und 6 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Der Erfindung liegt der Gedanke zugrunde, eine gattungsgemäße Vorrichtung beziehungsweise ein gattungsgemäßes Verfahren dadurch weiterzubilden, indem Lösungsmittel in einen durch den Filmrahmen und den daran befestigten Film gebildeten Lösungsmittelbehälter eingebracht wird. Durch die Elastizität oder Flexibilität des auf dem Filmrahmen montierten Films ist es gleichzeitig möglich, den Lösungsmittelbehälter volumenveränderlich zu gestalten und die Elastizität oder Flexibilität des Films wird außerdem genutzt, um das Produktsubstrat schonend und vom Rand des Produktsubstrats her abzulösen. Auf diese Weise steht das Produktsubstrat unmittelbar nach dem Abtrennen für weitere Prozessschritte zur Verfügung und ist durch den Film und den Filmrahmen geschützt. Viele Prozessschritte können direkt an dem filmrahmenmontierten Produktsubstrat durchgeführt werden.

Mit Produktsubstrat ist ein Produktsubstrat, beispielsweise ein Halbleiterwafer, gemeint, das üblicherweise auf eine Dicke zwischen 0,5 µm und 250 µm gedünnt ist, wobei die Tendenz zu immer dünneren Produktsubstraten geht. Besonders effektiv arbeitet die vorliegende Erfindung mit Produktsubstraten, die selbst eine ähnliche Flexibilität wie der am Filmrahmen montierte Film aufweisen. Das Produktsubstrat wird bei der erfindungsgemäßen Vorrichtung beziehungsweise dem erfindungsgemäßen Verfahren von dem Trägersubstrat abgeschält, insbesondere konzentrisch vom Umfang des Produktsubstrats ausgehend.

Als Träger wird beispielsweise ein Trägersubstrat mit einer Dicke zwischen 50 µm und 5.000 µm, insbesondere zwischen 500 µm und 1000 µm verwendet.

Als Verbindungsschicht kommt ein Kleber, beispielsweise ein lösbarer Kleber, insbesondere ein Thermoplast in Frage, der beispielsweise selektiv in einem Randbereich des Träger-Produktsubstrat-Verbundes, insbesondere in einer Randzone von 0,1 bis 20 mm, aufgebracht wird. Alternativ kann der Kleber vollflächig aufgebracht werden, wobei die Klebekraft im Zentrum durch eine haftreduzierende Schicht, beispielsweise ein Fluorpolymer, vorzugsweise Teflon, reduziert sein kann.

Als Aufnahmeeinrichtung eignet sich besonders ein Chuck, insbesondere ein Spinner Chuck zur Aufnahme des Trägersubstrats, insbesondere mittels Unterdruck, beispielsweise an Saugbahnen, Bohrungen oder Saugnäpfen. Alternativ ist eine mechanische Aufnahme, beispielsweise durch seitliche Klammern, denkbar. In einer weiteren, alternativen Ausgestaltung erfolgt die Aufnahme elektrostatisch.

Die Ablösungsmittel umfassen den auf den Filmrahmen montierten Film und eine den Filmrahmen aufnehmende und kraftbeaufschlagende Filmrahmenaufnahme.

In einer vorteilhaften Ausführungsform der Erfindung ist vorgesehen, dass das Lösungsmittel im Wesentlichen erhitzungsfrei arbeitend ausgebildet ist. Das Lösungsmittel wird vorzugsweise bei Umgebungstemperatur eingesetzt. Auf diese Weise ist es möglich, auf jegliche Heizeinrichtung zu verzichten.

Indem das Lösungsmittel zur zumindest partiellen Lösung der durch die Verbindungsschicht bewirkten Verbindung zwischen dem Trägersubstrat und dem Produktsubstrat vorgesehen ist, wird das Ablösen durch die Ablösemittel mit Vorteil deutlich erleichtert.

Dadurch, dass das Lösungsmittel, insbesondere ein die Verbindungsschicht selektiv auflösendes, Fluidmittel zur zumindest partiellen Lösung der Verbindungsschicht umfasst, wird bei verschiedene Kleber umfassenden Verbindungsschichten ermöglicht, eine bestimmte Verbindungsschicht gezielt oder in definierten Regionen aufzulösen. Die chemische Auflösung der Verbindungssicht ist für das Produktsubstrat dabei besonders schonend und bei entsprechender Materialwahl kann die Auflösung auch sehr schnell erfolgen, insbesondere wenn nur Randbereiche des Produktsubstrats mit einer Verbindungsschicht versehen sind, so dass das Lösungsmittel von der Seite her schnell wirken kann. Auf diese Weise kann auf Perforierungen im Trägersubstrat und/oder Produktsubstrat verzichtet werden.

Soweit der Lösungsmittelbehälter derart ausgebildet ist, dass das Lösungsmittel zumindest am Beginn des Lösens der Verbindungsschicht, insbesondere ausschließlich, im Bereich eines Umfangs des Produktsubstrats wirkt, kann auf eine Einwirkung des Produktsubstrats und/oder Trägersubstrats von der Oberseite und/oder der Unterseite, insbesondere einem innerhalb des Seitenrandes liegenden Innenbereich des Produktsubstrats, verzichtet werden.

In einer weiteren vorteilhaften Ausgestaltung der Erfindung ist vorgesehen, dass die Ablösungsmittel eine auf das Trägersubstrat wirkende Kraft Fₛ und eine entgegen der Kraft Fₛ gerichtete, auf den Filmrahmen wirkenden Kraft F_{f} bewirkend ausgebildet sind. Hierdurch wird auf einfache und durch den Film besonders schonende Art und Weise das Ablösen bewerkstelligt. Die Kraft F_{f} wirkt am Umfang des Filmrahmens, insbesondere an mindestens zwei, über den Umfang verteilten Stellen des Filmrahmens, wobei die Kräfte F_{f1} und F_{f2} in einer vorteilhaften Ausführungsform unterschiedlich gesteuert werden können, um das Produktsubstrat von der Seite her mit der größeren Kraft F_{f} abzulösen.

Dabei ist es von besonderem Vorteil, wenn der Film, insbesondere durch die Kraft Fs und die Kraft Ff, in einem zwischen dem Kontaktierungsflächenabschnitt und dem Befestigungsabschnitt liegenden Ablöseabschnitt spannbar ist. Hierdurch wird das Ablösen schonend am Umfang des Produktsubstrats bewirkt. Das Lösen durch das Lösungsmittel und das Ablösen durch die Kräfte Fₛ und F_{f} unterstützt sich dabei gegenseitig.

Gemäß einer vorteilhaften Ausführungsform der Erfindung ist vorgesehen, dass ein auf das Lösungsmittel und/oder die Verbindungsschicht einwirkender, insbesondere am Film anliegender und/oder in das Lösungsmittel im Lösungsmittelbehälter einbringbarer, Schwingungserzeuger vorgesehen ist. Einbringbar umfasst sowohl einen Oberflächenkontakt als auch ein zumindest teilweises Eintauchen. Dieser unterstützt das Lösen durch das Lösungsmittel und beschleunigt den Lösungsvorgang mindestens um den Faktor 2, bei optimierter Ausgestaltung um den Faktor 5, noch bevorzugter um den Faktor 10 bis 50. Vorzugsweise wirkt der Schwingungserzeuger durch Ultraschallwellen, insbesondere im Bereich des Kontaktierungsflächenabschnitts.

In einer weiteren vorteilhaften Ausführungsform ist der Lösungsmittelbehälter wannenförmig ausgebildet, wodurch mit einem minimalen Lösungsmittelverbrauch die Ablösung des Produktsubstrats erreicht werden kann.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1a:: Eine schematische Aufsicht auf einen aus Produktsubstrat, Trägersubstrat und Verbindungsschicht bestehenden Substratverbund auf einem Filmrahmen,
- Fig. 1b:: eine schematische Seitenansicht zu Figur 1a mit einer Detailansicht,
- Figur 2:: eine schematische Darstellung gemäß Figur 2 beim Einbringen des Lösungsmittels,
- Figur 3: eine schematische Darstellung eines Verfahrensausschnitts des Lösens der Verbindungsschicht,
- Figur 4:: eine schematische Darstellung eines erfindungsgemäßen Verfahrensschritts des Ablösens des Produktsubstrats vom Trägersubstrat.
- Figur 5:: eine schematische Darstellung eines alternativen erfindungsgemäßen Verfahrensschritts des Ablösens des Produktsubstrats vom Trägersubstrat.

In den Figuren sind gleiche Bauteile und Bauteile mit der gleichen Funktion mit den gleichen Bezugszeichen gekennzeichnet.

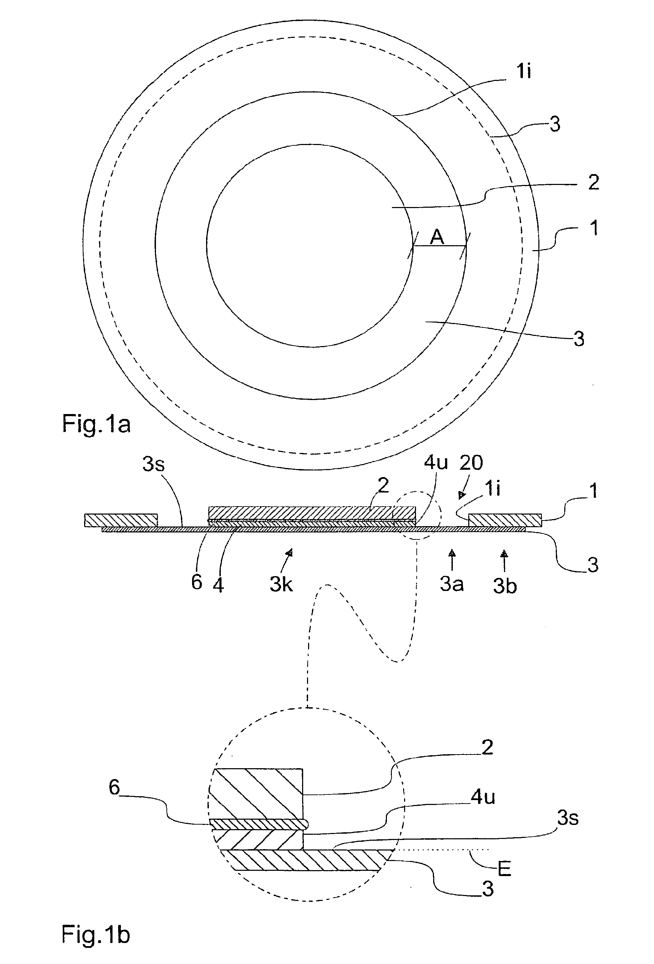

In Figur 1a ist ein in dieser Ausführungsform zumindest an einem Innenumfang 1i kreisrunder Filmrahmen 1 gezeigt, an dessen Unterseite gemäß der in Figur 1b gezeigten Schnittansicht ein Film 3 mit seiner Klebeschicht 3s konzentrisch zu dem Filmrahmen 1 aufgeklebt ist. Mit einem Radialabstand A zu dem Innenumfang 1i des Filmrahmens 1 ist innerhalb des Filmrahmens 1 ein Produktsubstrat-Trägersubstrat-Verbund auf der Klebeschicht 3s des Films 3 konzentrisch zu dem Filmrahmen 1 aufgeklebt. Der Produktsubstrat-Trägersubstrat-Verbund besteht aus einem am Film 3 haftenden Produktsubstrat 4, einem Trägersubstrat 2 und einer das Produktsubstrat 4 und das Trägersubstrat 2 verbindenden Verbindungsschicht 6. Die Durchmesser des Produktsubstrats 4 und des Trägersubstrats 2 sind im Wesentlichen identisch, während die Dicke des Produktsubstrats 4 geringer ist als die Dicke des Trägersubstrats 2.

Der Film 3 besteht aus einem im vorliegenden Fall kreisringförmigen Befestigungsabschnitt 3b, in welchem der Film 3 mit dem Filmrahmen 1 fixiert ist. Weiterhin besteht der Film 3 aus einem Kontaktierungsflächenabschnitt 3k, in welchem das Produktsubstrat 4 an der Klebeschicht 3s des Films 3 fixierbar ist. Zwischen dem Befestigungsabschnitt 3b und dem Kontaktierungsflächenabschnitt 3k liegt ein, insbesondere konzentrisch zu dem Befestigungsabschnitt 3b und dem Kontaktierungsflächenabschnitt 3k angeordneter Ablöseabschnitt 3a, der keine Klebefunktion aufweisen muss, dem aber eine erfindungsgemäß entscheidende Funktion zukommt. Der Ablöseabschnitt 3a erstreckt sich damit von einem Umfang 4u des Produktsubstrats 4 bis zu dem Innenumfang 1i des Filmrahmens 1, vorliegend als Radialabstand A bezeichnet. Das Verhältnis zwischen einer Dicke D des Filmrahmens 1 und des Abstands A beträgt im Vorteil mindestens 1:2 bis 1:50, insbesondere 1:5 bis 1:25.

In der in Figur 1b gezeigten Ausgangslage sind die den Film 3 kontaktierende Seite des Produktsubstrats 4 und die den Film 3 kontaktierende Seite des Filmrahmens 1 fluchtend und in einer Ebene E angeordnet. Die in den Figuren 1a und 1b gezeigten Teile werden auf einen bekannten Filmframe-Mounter zusammengebaut.

Der Film 3 und der Innenumfang 1i des Filmrahmens 1 bilden einen wannenförmigen Lösungsmittelbehälter 20, in welchem wie vorbeschrieben der Produktsubstrat-Trägersubstrat-Verbund anordenbar ist.

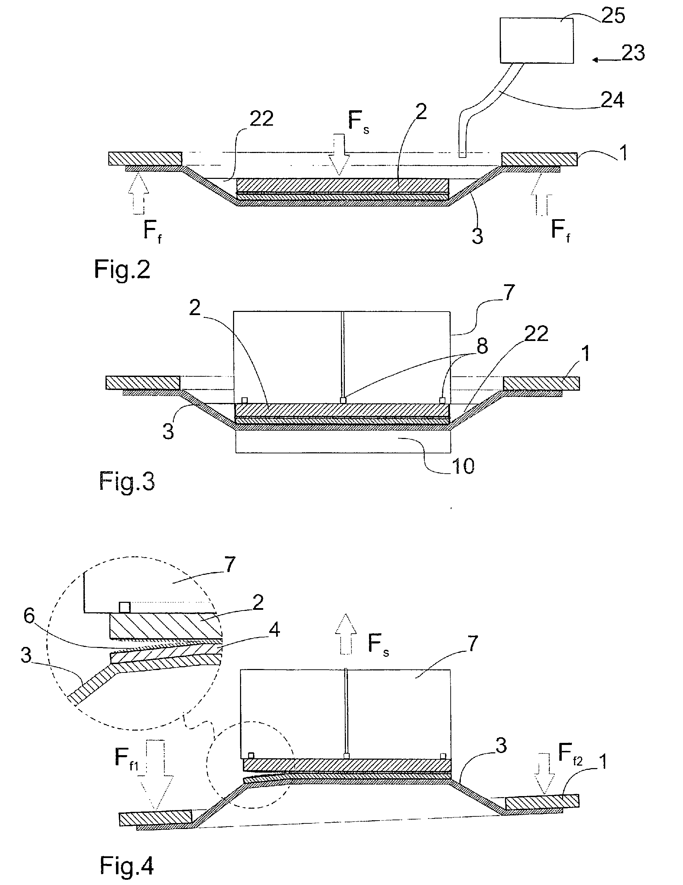

Gemäß dem in Figur 2 gezeigten Verfahrensschritt ist Lösungsmittel 22 durch Einbringmittel 23 in den Lösungsmittelbehälter 20 einbringbar. Die Einbringmittel 23 bestehen vorliegend aus einer Leitung 24 und einem Lösungsmittelvorrat 25, die von einer Zentraleinheit ansteuerbar sind, um Lösungsmittel 22 in den Lösungsmittelbehälter 20 einzubringen.

Wie in Figur 2 gezeigt, ist der Lösungsmittelbehälter 20 durch den zumindest im Ablöseabschnitt 3a elastischen Film 3 volumenveränderlich, indem eine Kraft Fₛ auf das Trägersubstrat 2 nach unten und eine Kraft F_{f} auf den Filmrahmen 1 nach oben wirkt. Die Krafteinbringung wird ebenfalls durch eine Zentraleinheit gesteuert.

Durch die Vergrößerung des Vorratsmittelbehältervolumens wird verhindert, dass Lösungsmittel 22 über den Rand des Filmrahmens 1 läuft und gleichzeitig wird eine schnelle Verteilung oder Einbringung des Lösungsmittels 22 ermöglicht.

Die Kraft Fₛ wird gemäß Figur 3 über eine Trägersubstrataufnahme 7 zur Aufnahme des Trägersubstrats 2 übertragen, wobei die Fixierung des Trägersubstrats 2 auf der Trägersubstrataufnahme 7 durch in die Oberfläche der Trägersubstrataufnahme 7 eingearbeitete Vakuumbahnen 8 und eine daran angeschlossene, nicht dargstellte Vakuumeinrichtung erfolgt.

Auf der gegenüberliegenden Seite des Films 3 zum Produktsubstrat 4 ist ein Schallwellenerzeuger 10, insbesondere zur Erzeugung von Ultraschallwellen, anordenbar, durch welchen Ultraschallwellen auf das Produktsubstrat 4, insbesondere jedoch auf die Verbindungsschicht 6 und das Lösungsmittel 22 übertragen werden können, da hierdurch der Vorgang des Lösens stark beschleunigt wird, insbesondere um eine Faktor 2, vorzugsweise um eine Faktor 5, noch bevorzugter um einen Faktor 10 bis 50.

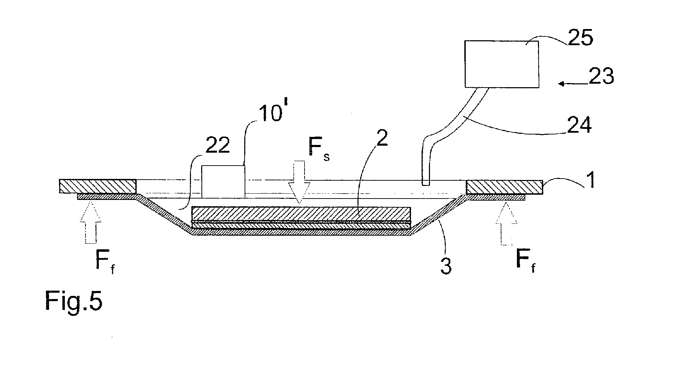

Gemäß einer alternativen, in Figur 5 gezeigten Ausführungsform ist der Schallwellenerzeuger 10' zumindest mit der Oberfläche des fluiden Lösungsmittels 22 in Kontakt, vorzugsweise aber in dieses zumindest teilweise eingetaucht. Hierdurch können die Schallwellen direkt auf das Lösungsmittel 22 und vom Lösungsmittel 22 auf die Verbindungsschicht 6 übertragen werden.

Die auf den Filmrahmen 1 wirkende Kraft F_{f} kann - wie in Figur 3 dargestellt - gleichmäßig verteilt als Flächenkraft auf den Filmrahmen 1 wirken, so dass über die Verformung des Films 3 im Ablöseabschnitt 3a die Volumenveränderung des Lösungsmittelbehälters 20 bewirkt werden kann.

Umgekehrt erfolgt gemäß Figur 4 das Ablösen des Produktsubstrats 2 vom Trägersubstrat 4, indem die Kräfte Fₛ und F_{f} beziehungsweise Fₛ₁ und Fₛ₂ in jeweils entgegengesetzter Richtung gerichtet werden, wobei die Kraft F_{f1} bei der hier gezeigten Ausführungsform größer als die Kraft F_{f2} eingestellt wird, um die Ablösung des Produktsubstrats 4 schonend zunächst von einer Randseite gemäß der in Figur 4 gezeigten Vergrößerung starten zu lassen.

Die Kraft F_{f1} beziehungsweise mehrere Kräfte F_{f1}, F_{f2} bis F_{fn} kann/können punktuell verteilt am Umfang des Filmrahmens 1 eingeleitet werden oder durch eine Filmrahmenaufnahme verteilt eingebracht werden.

Soweit die Kräfte F_{f1}, F_{f2} und/oder F_{fn} unterschiedlich ausgebildet sind, muss die Aufnahmeeinrichtung zur Einleitung der Kraft in den Filmrahmen 1 ein Kippen des Filmrahmens 1 zulassend ausgebildet sein.

Zwischen dem in Figur 3 dargestellten Verfahrensschritt des Lösens durch das Lösungsmittel 22 und dem in Figur 4 dargestellten Verfahrensschritt des Ablösens durch entgegengesetzte Kräfte Fₛ, F_{f1}, F_{f2}, F_{fn} kann ein Verfahrensschritt vorgesehen sein, durch den das Lösungsmittel 22 aus dem Lösungsmittelbehälter 20 entfernt wird, insbesondere durch Absaugen.

### Bezugszeichenliste

- 1: Filmrahmen
- 2: Trägersubstrat
- 3: Film
- 3a: Ablöseabschnitt
- 3b: Befestigungsabschnitt
- 3k: Kontaktierungsflächenabschnitt
- 3s: Klebeschicht
- 4: Produktsubstrat
- 4u: Umfang
- 6: Verbindungsschicht
- 7: Trägersubstrataufnahme
- 8: Vakuumbahnen
- 10, 10': Schallwellenerzeuger
- 20: Lösungsmittelbehälter
- 22: Lösungsmittel
- 23: Einbringmittel
- 24: Leitung
- 25: Lösungsmittelvorrat
- F_{f}, F_{f1}, F_{f2} ... F_{fn}: Kraft
- Fs: Kraft

## Patentansprüche

1. Lösungsmittelbehälter zum Lösen einer Verbindungsschicht (6) zwischen einem Produktsubstrat (4) und einem damit verbundenen Trägersubstrat (2) mit folgenden Merkmalen:
- ein Filmrahmen (1),
- ein mit dem Filmrahmen (1) verbundener, flexibler Film (3), der eine Klebeschicht (3s) zur Aufnahme des Produktsubstrats (4) in einem Kontaktierungsflächenabschnitt (3k) des Films (3) aufweist, wobei der Film (3) in einem den Kontaktierungsflächenabschnitt (3k) umgebenden Befestigungsabschnitt (3b) des Films (3) mit dem Filmrahmen (1) verbunden ist, **dadurch gekennzeichnet, dass** der Lösungsmittelbehälter (20) zur Aufnahme des Lösungsmittels (22) zum Lösen der Verbindungsschicht (6) durch den Filmrahmen (1) und den Film (3) gebildet ist und dass das Produktsubstrat (4) und die Verbindungsschicht (6) im Lösungsmittelbehälter (20) aufnehmbar sind.

2. Lösungsmittelbehälter (20) nach Anspruch 1, der volumenveränderlich ausgebildet ist.

3. Lösungsmittelbehälter (20) nach einem der vorhergehenden Ansprüche, der derart ausgebildet ist, dass das Lösungsmittel (22) zumindest am Beginn des Lösens der Verbindungsschicht (6), insbesondere ausschließlich, im Bereich eines Umfangs (4u) des Produktsubstrats (4) wirkend ausgebildet ist.

4. Lösungsmittelbehälter (20) nach einem der vorhergehenden Ansprüche,
**dadurch gekennzeichnet,**
**dass** der Film (3), insbesondere durch eine auf das Trägersubstrat wirkende Kraft Fs und eine entgegen der Kraft Fs gerichtete, auf den Filmrahmen (1) wirkende Kraft Ff, in einem zwischen dem Kontaktierungsflächenabschnitt (3k) und dem Befestigungsabschnitt (3b) liegenden Ablöseabschnitt (3a) spannbar ist.

5. Lösungsmittelbehälter (20) nach einem der vorhergehenden Ansprüche, der wannenförmig ausgebildet ist.

6. Verfahren zum Lösen einer Verbindungsschicht (6) zwischen einem Produktsubstrat (4) und einem damit verbundenen Trägersubstrat (2) mit folgenden Schritten:
- Ausbildung eines durch einen Filmrahmen (1) und einen mit dem Filmrahmen verbundenen, flexiblen Film (3) gebildeten Lösungsmittelbehälters (20) zur Aufnahme von Lösungsmittel (22) zum Lösen der Verbindungsschicht (6),
- Aufnahme des Produktsubstrats (4) und der Verbindungsschicht (6) im Lösungsmittelbehälter (20) und
- Einbringung von Lösungsmittel (22) in den Lösungsmittelbehälter (20) und Lösen der Verbindungsschicht (6).

7. Verfahren nach Anspruch 6,
**dadurch gekennzeichnet,**
**dass** nach Einbringung des Lösungsmittels (22) und zumindest teilweisem Lösen der Verbindungsschicht (6) eine Ablösung des Produktsubstrats (4) vom Trägersubstrat (2) durch Ablösemittel erfolgt.

8. Verfahren nach Anspruch 6 oder 7,
**dadurch gekennzeichnet,**
**dass** das Lösungsmittel (22) zumindest am Beginn des Lösens der Verbindungsschicht (6), insbesondere ausschließlich, im Bereich eines Umfangs (4u) des Produktsubstrats (4) wirkt.

9. Verfahren nach einem der Ansprüche 6 bis 8,
**dadurch gekennzeichnet,**
**dass** die Ablösung durch eine auf das Trägersubstrat (2) wirkende Kraft Fs und eine entgegen der Kraft Fs gerichtete, auf den Filmrahmen (1) wirkenden Kraft Ff bewirkt wird.

10. Verfahren nach einem der Ansprüche 6 bis 9,
**dadurch gekennzeichnet,**
**dass** die Ablösung des Produktsubstrats (4) konzentrisch vom Umfang (4u) des Produktsubstrats (4) zum Zentrum (4z) des Produktsubstrats (4) erfolgt.

11. Verfahren nach einem der Ansprüche 6 bis 10,
**dadurch gekennzeichnet,**
**dass** das Produktsubstrats (4) mit dem Trägersubstrat (2) über eine verschiedene Kleber umfassende Verbindungsschicht verbunden wird.

12. Verfahren nach einem der Ansprüche 6 bis 11,
**dadurch gekennzeichnet,**
**dass** das Lösungsmittel (22), insbesondere ein die Verbindungsschicht (6) selektiv auflösendes, Fluidmittel zur zumindest partiellen Lösung der Verbindungsschicht umfasst.

13. Verfahren nach einem der Ansprüche 6 bis 12,
**dadurch gekennzeichnet,**
**dass** die Verbindungsschicht in definierten Regionen aufgelöst wird.

14. Verfahren nach einem der Ansprüche 6 bis 13,
**dadurch gekennzeichnet,**
**dass** die eine bestimmte von mehreren Verbindungsschichten gezielt aufgelöst wird.

## Claims

1. Solvent reservoir for stripping a bonding layer (6) situated between a product substrate (4) and a carrier substrate (2) connected to the product substrate (4) with the following features:
- a film frame (1),
- a flexible film (3) which is connected to the film frame (1) and which has an adhesive layer (3s) for holding the product substrate (4) in a contacting surface section (3k) of the film (3), the film (3) being connected to the film frame (1) in an attachment section (3b) of the film (3) which surrounds the contacting surface section (3k), **characterized in that** the solvent reservoir (20) for receiving the solvent (22) for detaching the bonding layer (6) is formed by the film frame (1) and the film (3) and **in that** the product substrate (4) and the bonding layer (6) can be received in the solvent reservoir (20).

2. Solvent reservoir (20) as claimed in Claim 1, which is of variable volume.

3. Solvent reservoir (20) as claimed in one of the preceding claims, wherein the solvent reservoir (20) is made such that the solvent (22) at least at the start of detachment of the bonding layer (6) acts especially exclusively in the region of the periphery (4u) of the product substrate (4).

4. Solvent reservoir (20) as claimed in one of the preceding claims, wherein the film (3) can be clamped, especially by the force Fs which is acting on the carrier substrate (2) and a force Ff which is acting on the film frame (1) and which is directed against the force Fs, in a stripping section (3a) which lies between the contacting surface section (3k) and the attachment section (3b).

5. Solvent reservoir (20) as claimed in one of the preceding claims, wherein the solvent reservoir (20) is made trough-shaped.

6. Method for stripping a bonding layer (6) situated between a product substrate (4) and a carrier substrate (2) connected to the product substrate (4) with the following steps:
- forming a solvent reservoir (20) for holding solvent (22) for detaching the bonding layer (6) which is formed by a film frame (1) and a flexible film (3) connected to the film frame,
- holding the product substrate (4) and the bonding layer (6) in the solvent reservoir (20) and
- delivering solvent (22) into the solvent reservoir (20) and stripping of the bonding layer (6).

7. Method as claimed in Claim 6, wherein after delivering of the solvent (22) and at least partial stripping of the bonding layer (6) detaching the product substrate (4) from the carrier substrate (2) is effected.

8. Method as claimed in Claim 7 or 8, wherein the solvent (22) acts at least at the start of detachment of the bonding layer (6), especially solely in the region of the periphery (4u) of the product substrate (4).

9. Method as claimed in one of Claims 6 to 8, wherein detachment is caused by a force Fs acting on the carrier substrate (2) and a force Ff which is acting on the film frame (1) and which is directed against the force Fs.

10. Method as claimed in one of Claims 6 to 9, wherein detachment of the product substrate (4) takes place concentrically from the periphery (4u) of the product substrate (4) to the center (4z) of the product substrate (4).

11. Method as claimed in one of Claims 6 to 10, wherein the product substrate (4) is bonded to the carrier substrate (2) by means of a bonding layer containing different adhesives.

12. Method as claimed in one of Claims 6 to 11, wherein the solvent (22) comprises a fluid means which selectively dissolves the bonding layer (6), for at least partial detachment of the bonding layer (6).

13. Method as claimed in one of Claims 6 to 12, wherein bonding layer is dissolved in defined regions.

14. Method as claimed in one of Claims 6 to 13, wherein a specific of more than one bonding layers is dissolved selectively.

## Revendications

1. Réservoir à solvant pour dissoudre une couche d'assemblage (6) entre un substrat de produit (4) et un substrat porteur (2) assemblé avec ce dernier, avec les attributs suivants :
- un cadre pour un film (1),
- un film (3) flexible, relié avec le cadre pour film (1) qui comporte une couche collante (3s) destinée à recevoir le substrat de produit (4), dans une partie de surface de contact (3k) du film (3), le film (3) étant relié avec le cadre pour film (1) dans une partie de fixation (3b) du film (3) entourant la partie de surface de contact (3k), **caractérisé en ce que** le réservoir à solvant (20) pour recevoir le solvant (22) destiné à dissoudre la couche d'assemblage (6) est formé par le cadre pour film (1) et par le film (3) et **en ce que** le substrat de produit (4) et la couche d'assemblage (6) peuvent être réceptionnés dans le réservoir à solvant (20).

2. Réservoir à solvant (20) selon la revendication 1, qui est conçu avec un volume variable.

3. Réservoir à solvant (20) selon l'une quelconque des revendications précédentes qui est conçu de telle sorte qu'au moins au début de l'opération consistant à dissoudre la couche d'assemblage (6), notamment uniquement dans la zone d'une périphérie (4u) du substrat de produit (4), le solvant (22) est conçu en version active.

4. Réservoir à solvant (20) selon l'une quelconque des revendications précédentes, **caractérisé en ce que** le film (3) peut se tendre dans une partie de décollement (3a) située entre la partie de surface de contact (3k) et la partie de fixation (3b), notamment par une force Fs agissant sur le substrat porteur et une force Ff orientée à l'encontre de la force Fs, agissant sur le cadre pour film (1).

5. Réservoir à solvant (20) selon l'une quelconque des revendications précédentes lequel est conçu en forme de cuve.

6. Procédé destiné à dissoudre une couche d'assemblage (6) entre un substrat de produit (4) et un substrat porteur (2) assemblé avec ce dernier, avec les étapes suivantes :
- création d'un réservoir à solvant (20) formé par un cadre pour film (1) et un film (3) flexible relié avec le cadre pour film, destiné à recevoir un solvant (22) pour dissoudre la couche d'assemblage (6),
- réception du substrat de produit (4) et de la couche d'assemblage (6) dans le réservoir à solvant (20) et
- introduction de solvant (22) dans le réservoir à solvant (20) et décollement de la couche d'assemblage (6).

7. Procédé selon la revendication 6, **caractérisé en ce qu'**après l'introduction du solvant (22) et dissolution au moins partielle de la couche d'assemblage (6), il s'effectue un décollement du substrat de produit (4) du substrat porteur (2) par solvant.

8. Procédé selon la revendication 6 ou la revendication 7, **caractérisé en ce qu'**au moins au début de la dissolution de la couche d'assemblage (6), le solvant (22) agit notamment uniquement dans la zone d'une périphérie (4u) du substrat de produit (4).

9. Procédé selon l'une quelconque des revendications 6 à 8, **caractérisé en ce que** le décollement est provoqué par une force Fs agissant sur le substrat porteur (2) et par une force Ff dirigée à l'encontre de la force Fs et agissant sur le cadre pour film (1).

10. Procédé selon l'une quelconque des revendications 6 à 9, **caractérisé en ce que** le décollement du substrat de produit (4) s'effectue de manière concentrique à partir de la périphérie (4u) du substrat de produit (4) vers le centre (4z) du substrat de produit (4).

11. Procédé selon l'une quelconque des revendications 6 à 10, **caractérisé en ce qu'**on assemble le substrat de produit (4) avec le substrat porteur (2) par l'intermédiaire d'une couche d'assemblage comprenant différentes colles.

12. Procédé selon l'une quelconque des revendications 6 à 11, **caractérisé en ce que** le solvant (22), comprend un produit fluide, dissolvant notamment de manière sélective la couche d'assemblage (6) pour décoller au moins partiellement la couche d'assemblage.

13. Procédé selon l'une quelconque des revendications 6 à 12, **caractérisé en ce qu'**on dissout la couche d'assemblage dans des régions définies.

14. Procédé selon l'une quelconque des revendications 6 à 13, **caractérisé en ce qu'**on dissout l'une des couches précise parmi plusieurs couches d'assemblage.
